Europäisches Patentamt

European Patent Office

Office européen des brevets

(19)

(11) Publication number : **0 490 501 A2**

(12)                     **EUROPEAN PATENT APPLICATION**

(21) Application number : **91310637.3**

(22) Date of filing : **19.11.91**

(51) Int. Cl.⁵ : **C23G 5/04, C23G 5/02**

(30) Priority : **11.12.90 GB 9026848**
**13.09.91 GB 9119617**

(43) Date of publication of application :
**17.06.92 Bulletin 92/25**

(84) Designated Contracting States :
**AT BE CH DE DK ES FR GB IT LI NL SE**

(71) Applicant : **IMPERIAL CHEMICAL
INDUSTRIES PLC**
**Imperial Chemical House, Millbank**
**London SW1P 3JF (GB)**

(72) Inventor : **Weemes, Geoffrey Charles**
**5 Linden Drive**
**Mickle Trafford, Chester (GB)**
Inventor : **Garvey, Kevin Michael**
**Wychbold, Grange Lane**
**Whitegate, Northwich CW8 2BQ (GB)**

(74) Representative : **Collingwood, Anthony Robert
et al**
**Imperial Chemical Industries PLC Legal
Department: Patents P.O. Box 6 Bessemer
Road**
**Welwyn Garden City Hertfordshire AL7 1HD
(GB)**

(54) **Cleaning of articles.**

(57)    Articles contaminated with soil etc are cleaned by contact with a non-chlorinated organic solvent having a relatively low flashpoint, such contact being made at a temperature below such flashpoint. The articles are then contacted with an aqueous rinsing medium at a temperature below the flashpoint of the solvent. These steps lead to contamination of the solvent and the rinsing medium and to free them of the contaminants, which are substantially non-volatile, the contaminated solvent and rinsing medium are fed to a steam distillation unit in which the rinsing medium and solvent are co-distilled at a temperature above the flashpoint of the solvent. The steam distillation is carried out in a fire hazard containment zone in which oxygen is substantially excluded during normal operation of the steam distillation unit by the water/solvent vapour generated, and during commencement and cessation phases of steam distillation by the generation of an inert gaseous fluid.

Fig. 1.

Jouve, 18, rue Saint-Denis, 75001 PARIS

This invention relates to the cleaning of contaminated articles using organic solvents.

In the past, halogenated solvents have been in widespread use for cleaning industrially manufactured articles and, whilst such solvents are particularly advantageous in terms of their volatility, absence of flash point and ability to dissolve contaminants typically encountered, the use of such solvents is currently perceived as being unsatisfactory from the environmental standpoint.

Alternative hydrocarbon solvents have been proposed such as terpene solvents; for example, see published European Patent Application No. 354027. However, known alternative solvents have relatively low flash points and are therefore potentially hazardous if used in cleaning plant in which the solvents are heated to elevated temperatures in the course of effecting cleaning of the articles and/or removing the solvent from the articles. Also, especially in the case of terpene solvents, cleaning efficiency deteriorates rapidly with build up of dissolved contaminants within the solvent thereby giving rise to a need for frequent replacement of spent solvent with fresh solvent.

According to one aspect of the invention there is provided a process for the cleaning of contaminated articles, comprising:

(a) contacting the articles with a non-chlorinated organic solvent at a temperature below the flashpoint thereof, the solvent being capable of combining with the contaminant(s);

(b) contacting the solvent bearing articles with an aqueous rinsing medium at a temperature below said flashpoint to effect removal of the solvent from the articles;

(c) collecting the contaminated solvent;

(d) heating the collected solvent in a fire hazard containment zone to produce a vapour containing the solvent;

(e) condensing the solvent vapour; and

(f) recycling the solvent from step (e) for further contact with the articles in step (a).

Thus, in accordance with the invention, a non-chlorinated (usually non-halogenated) solvent is used for cleaning of the articles and, in the course of the cleaning and rinsing stages, the solvent is at all times at a temperature below its flashpoint thereby eliminating any fire hazard, and the solvent is recovered in a heating stage separate from the solvent contacting and rinsing stages and forming a fire hazard containment zone.

Preferably the temperature of the rinsing medium in step (b) is at least 5°C, and often at least 10°C, below the flashpoint (closed cup) of the solvent.

Typically the temperature at which the solvent is contacted with the articles in step (a) is at least 5°C, often at least 10°C, below the flashpoint (closed cup) of the solvent.

Preferably contacting of the articles with the solvent is effected by immersion of the articles in the solvent and contacting of the solvent bearing articles is conveniently effected by immersion of the articles in the rinsing medium.

Usually, solvent collected from step (b) will contain rinsing medium; the collected mixture may either be separated and only the solvent treated in accordance with step (d) or it (the mixture) may be treated in accordance with step (d) in which case step (e) may comprise condensing the solvent and rinsing medium, the latter being recycled for use in step (b).

The recycled components, whether solvent or aqueous, are conveniently re-introduced in such a way as to displace contaminated solvent or rinsing medium respectively and the displaced quantities are fed to said zone for heating in accordance with step (d).

In general, the solvent will be non-halogenated and may comprise a hydrocarbon or mixture of hydrocarbons which may be in admixture with a co-solvent such as an alcohol. The organic solvent and the rinsing medium will in general be substantially immiscible with one another.

Preferably, in the fire hazard containment zone, oxygen is substantially excluded from contact with the solvent by producing an atmosphere of an inert gas or vapour which may be a liquid phase.

Usually contaminated solvent derived directly from step (a) is also supplied to the containment zone for treatment in accordance with steps (d) to (f).

According to a second aspect of the invention there is provided a process for the cleaning of contaminated articles, comprising:

(a) contacting the articles with a non-chlorinated organic solvent at a temperature below the flashpoint thereof, the solvent being capable of combining with the contaminant(s);

(b) contacting the solvent bearing articles with an aqueous rinsing medium at a temperature below said flashpoint to effect removal of the solvent from the articles;

(c) collecting at least the contaminated solvent from step (a) and/or (b);

(d) subjecting the collected solvent to steam distillation to produce a vapour containing the solvent and steam such that the steam is effective to substantially exclude oxygen thereby preventing ignition of the organic solvent vapour;

(e) condensing the vapour; and

(f) separating the solvent from the condensate.

Various other features and aspects of the invention will become apparent from the following description and the appended claims.

The invention will now be described by way of example with reference to the accompanying drawings, in which:

Figure 1 is a schematic view of cleaning plant in accordance with the invention and embodying one form of steam distillation unit/fire hazard containment zone;

Figures 2 to 4 are schematic views of alternative forms of steam distillation unit/ fire hazard containment zone which may be used in place of the steam distillation/fire hazard containment zone shown in Figure 1.

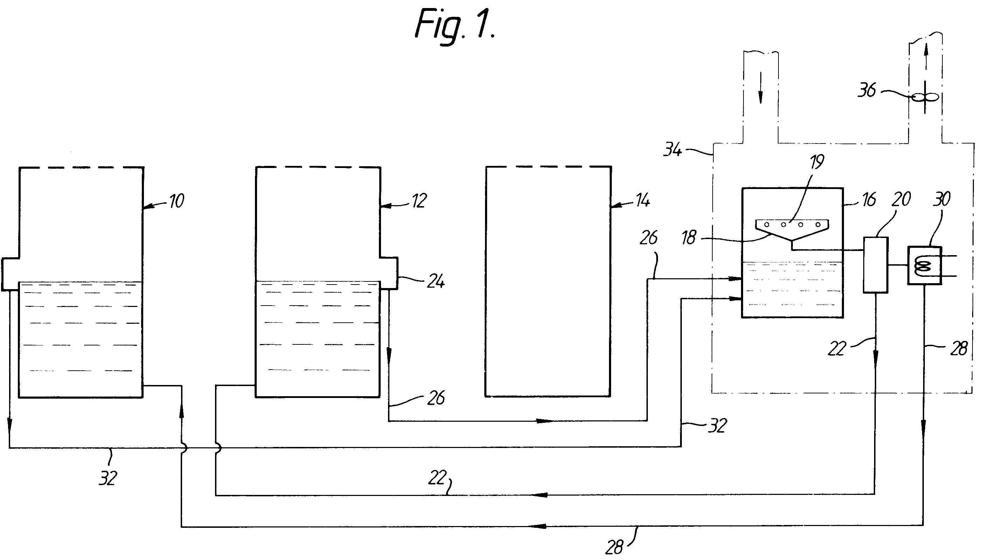

Referring to the Figure 1, the cleaning plant comprises a first tank 10 containing a non-chlorinated organic solvent (for example, a steam distillable terpene-based compound) suitable for dissolving the contaminants, such as grease, on articles to be cleaned. In a typical application, the articles comprise printed circuit boards from which rosin flux residues remaining after soldering processes are to be removed. The articles are typically introduced as a batch into the tank through the top thereof for immersion in the solvent. The solvent is maintained at a temperature substantially below its flashpoint, eg. about 35°C in the case of a terpene based solvent having a flashpoint of about 55°C. It is to be understood that the invention is not limited to terpene based solvents however; for example, the organic solvent may take various forms such as a mixture of non-halogenated hydrocarbons combined with a polar organic solvent, such as an alcohol, to increase the solvent power.

After immersion in the wash tank, the solvent-washed articles which will have a film of the hydrocarbon solvent on their surfaces are then immersed in one or more water rinse tanks 12 (only one is illustrated in the drawing) in which the temperature is held below the flashpoint of the hydrocarbon. Where more than one rinse tank 12 is used, they will be operated in cascade fashion with the rinse water flowing from the final rinse tank to the first. A rinse additive may be included in the water. Following rinsing, the articles are subjected to hot air drying in vessel 14, typically at a temperature of the order of 50 to 140°C. The contents of either or both of the tanks 10 and 12 may be agitated by any suitable means such as pump agitation or ultrasonic agitation.

During the cleaning cycle, the soil removed from the articles will tend to collect in the wash tank 10 and the rinse tank(s) 12 and the build up of the contaminant affects the efficiency of cleaning. To reduce the frequency of replacement of contaminated solvent with fresh solvent, the system incorporates a concentrator stage 16 which effects steam distillation. The concentrator vessel is pre-charged with a mixture of water and the organic solvent, the mixture containing water and organic solvent in proportions allowing co-distillation to be carried out at a temperature somewhat below the boiling point of the organic solvent. In the concentrator, the contents are heated to vaporise the water/organic solvent mixture. The vapour is condensed in a trough 18 equipped with cooling coils 19 or the like and the resulting liquid phase is fed to a separator 20 for separating the water from the organic solvent.

The water is then recycled via feed line 22 to the rinse tank 12 (or the final rinse tank when more than one rinse tank is used) and is introduced at or near to the base of the rinse tank so as to displace an equal volume of water. The displaced volume, which will contain the organic solvent and any contaminant carried over by the organic solvent, is extracted by means of a weir arrangement 24 and is fed via feed line 26 to the concentrator 16.

Similarly, the organic solvent from the separator 20 is fed via feedline 28 incorporating cooler 30 into the wash tank 10 at or adjacent the base thereof to displace contaminated organic solvent, eg. via a weir arrangement, and the displaced organic solvent is fed via feedline 32 to the concentrator vessel 16 for vaporisation. The cooler 30 is optionally provided in order to reduce the temperature of the organic solvent to a value below its flashpoint. Alternatively, the cooler 30 may be eliminated if the condenser 19 is designed so as to ensure that the condensed solvent is cooled to a temperature below its flashpoint.

Since the contamination will be non-volatile, it will remain in the concentrator vessel and only substantially pure water and organic solvent will be distilled off for recycle to the rinse and wash tanks respectively. To reduce the load on the concentrator, a separator (not shown) for separating the water and organic solvent may be fitted to the outlet of the water rinse tank (or final rinse tank where appropriate). The water from this separator may be fed to the concentrator while the organic solvent may be returned to the wash tank 10. The cleanliness levels of the wash and rinse tanks for a given contamination input rate and carryover rate is a function of the amount of organic solvent/water boiled off in the concentrator which is directly proportional to the heat input to the concentrator, thus allowing the cleanliness levels to be determined by control of the heat input to the concentrator.

In the concentrator, the organic solvent will be above its flashpoint and to eliminate fire hazards, the concentrator unit is designed accordingly and may be encased in a suitable enclosure 34 for containment of any fire risk, the interior of the enclosure 34 being maintained at a negative pressure by means of a fan 36. In practice, the contents of the enclosure will be classified as a flammable area and will be subject to appropriate safety measures, such as the exclusion of all potential spark-discharge producing equipment.

The cooler 30 is also enclosed within the enclosure 34 and downstream of the cooler, the temperature of the fluid within the feedline 28 is sensed by a suitable sensor (not shown) to ensure that the liquid is below its flashpoint by at least a predetermined amount; if the temperature registered by the sensor is above a preset level, means may be provided to produce an alarm and/or prevent further recycling of fluid from the enclosure 34 back to the wash tank 10.

Primary fire hazard containment is achieved by filling the interior of the vessel 16 with an inert gas such as nitrogen at least at start up of operation so as to exclude oxygen. In operation of the vessel 16, steam is generated which displaces the inert gas and the steam so generated excludes ingress of oxygen into the vessel 16 to maintain security against fire as a result of solvent vapour coming into contact with air at levels above the lower explosion limit of the solvent vapour. If desired, an inert gas atmosphere may be maintained in the interior of the enclosure 34.

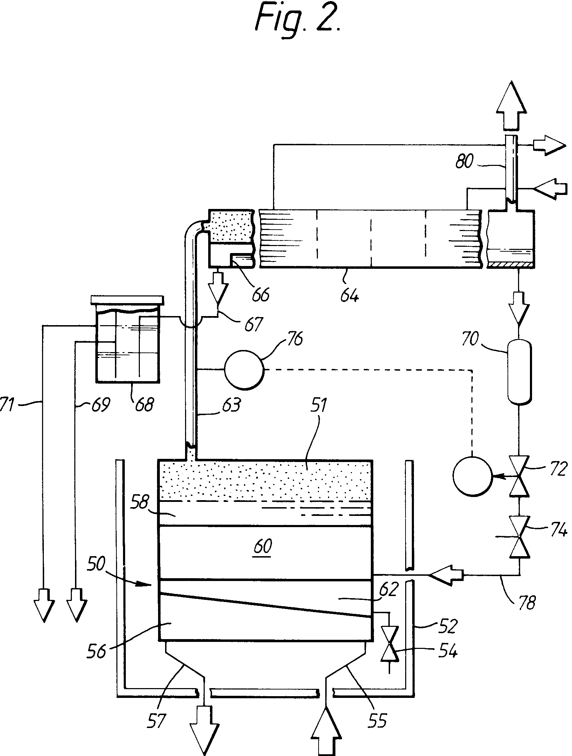

Referring now to Figure 2, the steam distillation unit or concentrator stage shown is intended to be used in place of that shown in Figure 1. The concentrator vessel 50 is located within a flame proof enclosure 52 from which all potential spark discharge-generating equipment, such as electrical motors etc, is excluded. Although not shown in Figure 2, solvent and water from the tanks 10 and 12 are supplied to the vessel 50 in the same manner as described in connection with Figure 1 and the vessel is pre-charged with solvent and water in predetermined proportions to produce a mixture which can be co-distilled at a temperature somewhat below the boiling point of the solvent; typically the mixture can be vaporised at a temperature of the order of 100°C. The base of the vessel 50 is sloped to allow the contaminant to collect for periodic drainage by opening of drain valve 54. The contents of the vessel 50 are heated by a heater comprising a chamber 56 through which hot fluid, eg water, is circulated via inlet and outlet lines 55 and 57, the temperature of the hot fluid being sufficient to heat the vessel contents to a temperature at which the water and solvent co-distil.

In addition to being charged with organic solvent and water (respectively depicted by reference numerals 58 and 60), the vessel 50 is also initially charged with an inerting liquid 62 which has a higher density than water and the organic solvent and a lower boiling point than the temperature at which the water/solvent mixture boils and also lower than the flashpoint of the solvent. Above the liquid contents of the vessel 50, headspace 51 is present in which vapour collects when the contents are heated. Vapour accumulating in the vessel interior passes through pipe 63 and into water cooled condenser/sub-cooler 64 in which the vapour is condensed and cooled to a temperature below the flashpoint of the solvent.

The lighter condensed water/solvent mixture is separated by a weir arrangement 66 and passes via line 67 to a phase separator 68 which is the counterpart of the separator 20 in Figure 1 and which has outlets 69, 71 for feeding water and solvent respectively back to the tanks 10 and 12. The heavier inerting liquid settles to the base of the condenser/sub-cooler 64 and is fed to a catchpot 70, the outlet of which is provided with a pair of valves 72, 74. Opening and closing of the valve 72 is controlled by a temperature controller 76 which is responsive to the temperature prevailing in the headspace 51 of the vessel 50. When open the valve 72 allows the inerting liquid to be returned to the vessel 50 via line 78 and, when closed, prevents such return flow so that the inerting liquid is stored in the catchpot 70. The valve 74 is a flow control valve which serves to control the rate at which the inerting liquid can flow back into the vessel 50.

In operation, at start-up the vessel 50 contains the inerting liquid which because of its higher density will reside at the base of the vessel. At this stage, the valve 72 is opened either manually or automatically in response to supply of heated fluid to the chamber 56. As the contents of the vessel are heated by flow of the heating fluid through the chamber 56, the inerting liquid by virtue of its lower boiling point begins to vaporise and fill the headspace 51 above the upper liquid level thereby displacing any air to atmosphere via vent 80 and hence excluding substantially all oxygen initially present in the headspace 51 prior to the commencement of vaporisation of the solvent/water mixture. At this stage, the inerting compound is circulated around a closed path comprising the vessel 50, condenser/sub-cooler 64, catchpot 70 and back to the vessel and is in the liquid phase as it passes through the catchpot and back to the vessel 50.

As the contents of the vessel 50 heat up further, the solvent/water mixture begins to vaporise, eg at a temperature close to 100 °C, and because of the inert vapour atmosphere already created in the headspace 51, solvent vapour generation takes place in substantially oxygen free conditions thereby minimising the risk of the solvent vapour being ignited. As heating continues, the headspace 51 gradually fills with solvent/water vapour which displaces the vapour generated from the inerting liquid and the temperature within the headspace 51 and hence the pipe 63 rises to the boiling point of the solvent/water mixture. When the temperature controller 76 registers a predetermined temperature corresponding to that at which the solvent/water mixture vaporises, eg about 100°C, the valve 72 is closed, possibly after a short time delay to ensure that the headspace is filled with the solvent/water vapour. Closure of the valve 72 leads to the inerting liquid being collected and stored in the catchpot 70 where it remains until the concentrator unit is to be shut-down.

In this manner, the solvent/water vapour gradually displaces the inerting vapour and the inerting liquid is removed from the vessel 50. At this stage, it will be noted that oxygen is substantially excluded by the atmosphere of steam and solvent vapour present in the headspace of the vessel 50 thereby minimising any risk of solvent vapour ignition. The separation of the contaminant from the solvent and water then proceeds in the fashion described in connection with Figure 1.

When the operation of the concentrator is to be discontinued, the fluid supply to chamber 56 is terminated and the heater begins to cool down. At this time or just prior to cessation of heating, the valve 72 is opened (eg. automatically in response to operation of a shut-down switch) thus allowing the inerting liquid to re-enter the vessel. Because of its low boiling point, vaporisation of the inerting liquid re-commences and the inerting vapour then builds up in the headspace to replace the solvent/water vapour which, following cessation of heating, begins to condense. By appropriate timing of opening of valve 72, it is possible to ensure that oxygen continues to be excluded from the headspace 51 while the solvent is in the vapour phase. This condition is then maintained until the contents of the vessel have cooled sufficiently below the flashpoint of the solvent and hence a safe condition attained. The inerting liquid may either be collected in the vessel 50 or in the catchpot 70 for re-use when the concentrator is next operational. In the latter event, it will be appreciated that the valve 72 will need to be opened on start-up to allow the inerting liquid to re-enter the vessel 50.

The inerting liquid may comprise any suitable chemically inert liquid having a sufficiently low boiling point that it will begin to vaporise before the organic solvent; usually it will also have a density greater than the aqueous rinsing medium and the solvent and be substantially immiscible with the rinsing medium and the organic solvent. Suitable compounds may be selected from highly or fully fluorinated organic compounds comprising predominantly carbon and fluorine atoms, optionally with a minor proportion of hydrogen atoms with or without oxygen or nitrogen atoms, eg a perfluoroalkane such as that manufactured by 3Ms under the trade name "Fluorinert" FC72.

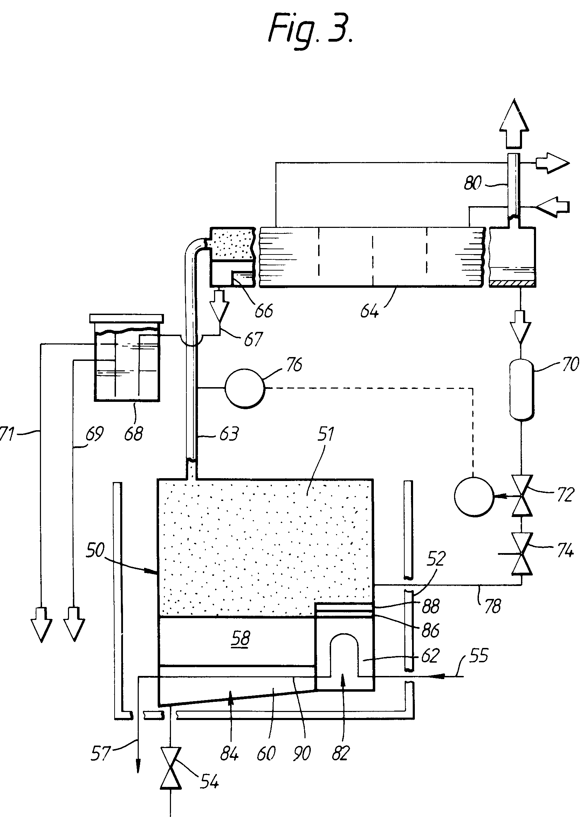

Referring to Figure 3, this illustrates another form of the steam distillation or concentrator unit which is similar to that shown in Figure 2 in many respects and like parts are therefore identified by the same reference numerals as used in Figure 2. This embodiment is adapted to ensure that the inerting fluid is vaporised in quantities sufficient to fill the headspace 51 rapidly. The vessel 50 is provided adjacent its base with two compartments 82 and 84, one (82) of which is intended to contain the inerting liquid 62 and the other (84) of which contains the main bulk of the water (layer 60) and organic solvent (layer 58) from which the contaminants are to be separated. In practice, the inerting liquid 62 will be covered by shallow layers of water and solvent 86, 88 but, in contrast with the embodiment of Figure 2, the vapour generated from the inerting liquid does not have to travel through the main bulk of the water and solvent in order to reach the headspace 51 which would otherwise tend to re-condense the vapour to some extent especially on initial start-up of operation.

Heating of the contents of the vessel 50 is effected by hot fluid passing through heat exchange piping 90 or the like, the latter being shaped as shown in order to provide an extended heating path within the compartment 82 and also to heat the inerting fluid directly at positions distributed throughout the depth of the compartment 82. Operation of this embodiment is generally the same as described in connection with Figure 2; during initial start-up, the inerting fluid (eg. Fluorinert FC72) is vaporised and accumulates in the headspace 51 to exclude oxygen and is cycled around a path including condenser/sub-cooler 64 and the catchpot 70 and back to the compartment 82. Once the temperature reaches a predetermined value indicative of the presence of a substantial quantity of solvent/water vapour in the headspace 51, the valve 72 is closed manually or automatically and the inerting liquid is collected in catchpot 70 and stored there until operation is to be discontinued. At shut-down, the valve 72 is opened to allow the inerting liquid to flow back into the compartment 82 so that, as the heat exchanger cools down, inert vapour is supplied to the headspace to maintain exclusion of oxygen until the contents of the vessel 50 have cooled to a point below the flashpoint of the solvent and hence a safe condition achieved.

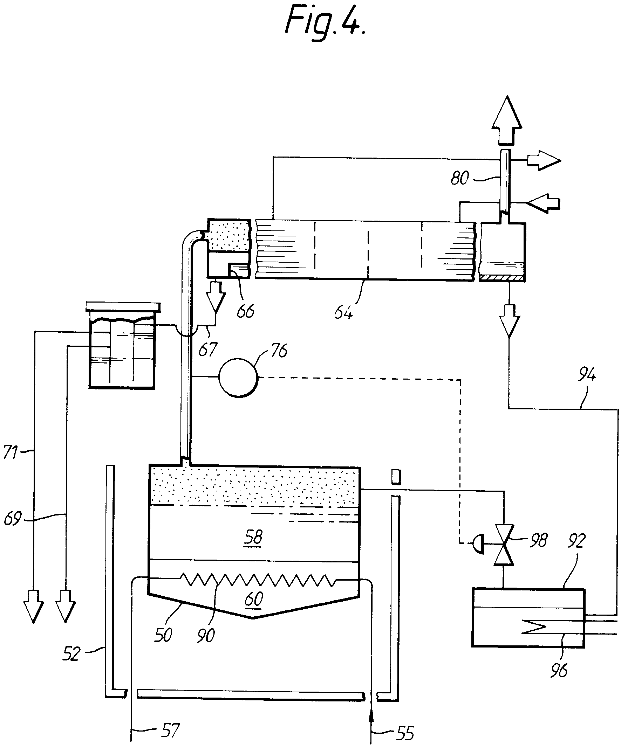

Referring to Figure 4 in which a further modification of the steam distillation/concentrator unit is shown. Again, where appropriate, the same reference numerals are used to indicate components in Figure 4 which are similar and function similarly to those shown in Figure 2. In the embodiments of Figures 2 and 3, the inerting liquid is heated within the vessel 50 by the same heating source as used to heat the water and solvent. In Figure 4, the inerting liquid is stored in a separate vessel 92 which receives, via line 94, condensed inerting fluid from the condenser/sub-cooler 64 and is provided with a heater 96 (which may be an electrical resistance heater for instance) for vaporising the inerting liquid within the vessel 92. The inerting vapour passes to the headspace 51 within vessel 50 via valve 98 which is controlled by means of controller 76 in similar fashion to valve 72 in Figure 2. Heating of the contents of vessel 50 is effected by hot fluid passing through heat exchanger 90.

In this embodiment, when operation of the concentrator unit is initiated, the heater 96 is energised and valve 98 is opened so that vapour is generated in vessel 92 and supplied to the headspace 51 for the purpose of excluding oxygen. Condensed inerting vapour is returned to the vessel 94 to complete the cycle. When the temperature prevailing in the headspace 51 reaches a predetermined value indicative of the presence of a substantial quantity of water/solvent vapour in the headspace, controller closes valve 98 and also produces a signal to switch off the heater 96. All of the inerting fluid is then gradually returned to the vessel where it is stored until shutdown of the concentrator unit. At shut-down or just prior thereto, heater 96 is energised and valve 98 opened to allow a blanket of vaporised inerting fluid to be generated in headspace 51 until the temperature within the vessel 50 falls to a point below the flashpoint of the solvent. At that stage, the heater 96 is switched off and the valve 98 is closed so that the inerting fluid can be collected in vessel 92.

In each of the embodiments shown in Figures 2 to 4, means may be provided for preventing the contents of the vessel being heated if the inerting fluid is not present or not present in a sufficient quantity to ensure adequate exclusion of oxygen. Thus, for example, in the embodiment of Figure 3, the compartment may house a float which has a density greater than that of the solvent and water but less than that of the inerting liquid so as to register the level of the inerting liquid within that compartment and means may be provided for sensing the position of the float prior to operation of the concentrator unit so that, if the float is below a predetermined position within the compartment 82, supply of heat, ie. in this case via the heat exchanger 90, is disabled and a signal may be produced to alert an operator to the need to top up the contents of the compartment 82. In addition, or alternatively, the compartment 82 may be provided with a transparent viewing window to enable the contents of the compartment 82 to be inspected with or without the aid of a float so that before initiating operation a check can be made that the inerting liquid content is within acceptable limits.

It will be seen that the steam distillation unit forms a hire hazard containment zone. Although the operating temperature of the steam distillation unit is above the flashpoint of the solvent, the risk of ignition of the solvent vapour when the distillation unit is in its normal steady state condition of operation is eliminated since air is precluded from entering the unit by the steam generated from the water which is boiling. Moreover, during heating up and cooling down of the liquid contents of the distillation unit, even though vapour generated from the solvent/water contents will pass through the flammable limits of the solvent (which would otherwise represent a potentially dangerous situation, such vapour is produced in the presence of the inerting vapour which serves to exclude air during the initial heating phase and during the cooling down phase of operation. The use of an inerting fluid as described in the embodiments of Figures 2 to 4 will be seen to be particularly effective compared with for example a nitrogen purging system which tends to be less safe and requires more intensive operator monitoring.

**Claims**

1. A process for the cleaning of contaminated articles, comprising:
   (a) contacting the articles with a non-chlorinated organic solvent at a temperature below the flashpoint thereof, the solvent being capable of combining with the contaminant(s);
   (b) contacting the solvent bearing articles with an aqueous rinsing medium at a temperature below said flashpoint to effect removal of the solvent from the articles;
   (c) collecting the contaminated solvent;
   (d) heating the collected solvent in a fire hazard containment zone to produce a vapour containing the solvent;
   (e) condensing the solvent vapour; and
   (f) recycling the solvent from step (e) for further contact with the articles in step (a).

2. A process as claimed in Claim 1 in which the heating step (d) is carried out in a steam distillation apparatus initially charged with said organic solvent and water.

3. A process as claimed in Claim 1 or 2 in which the temperature of the rinsing medium in step (b) is at least 5°C below the flashpoint (closed cup) of the solvent.

4. A process as claimed in Claim 1 or 2 in which the temperature of the rinsing medium in step (b) is at least 10°C below the flashpoint (closed cup) of the solvent.

5. A process as claimed in any one of Claims 1 to 4 in which the temperature at which the solvent is contacted with the articles in step (a) is at least 5°C below the flashpoint (closed cup) of the solvent.

6. A process as claimed in any one of Claims 1 to 4 in which the temperature at which the solvent is contacted with the articles in step (a) is at least 10°C below the flashpoint (closed cup) of the solvent.

7. A process as claimed in any one of Claims 1 to 6 in which the solvent is non-halogenated.

8. A process as claimed in any one of Claims 1 to 7 in which, in the fire hazard containment zone, oxygen is substantially excluded from contact with the solvent by producing an atmosphere of an inert gas or vapour.

9. A process as claimed in Claim 8 in which the inert gas/vapour is generated from a liquid phase.

10. A process as claimed in any one of Claims 1 to 9 in which contaminated solvent is collected from steps (a) and (b).

**11.** A process as claimed in Claim 10 in which both the rinsing medium and the solvent are collected from step (b) and are subjected to the heating of step (d).

**12.** A process as claimed in Claim 10 in which a mixture of said solvent and the rinsing medium is collected from step (b) and in which the mixture is subjected to a separation step prior to step (d), only the solvent fraction of the mixture being treated in accordance with step (d).

**13.** A process for the cleaning of contaminated articles, comprising:

(a) contacting the articles with a non-chlorinated organic solvent at a temperature below the flashpoint thereof, the solvent being capable of combining with the contaminant(s);

(b) contacting the solvent bearing articles with an aqueous rinsing medium at a temperature below said flashpoint to effect removal of the solvent from the articles;

(c) collecting at least the contaminated solvent from step (a) and/or (b);

(d) subjecting the collected solvent to steam distillation to produce a vapour containing the solvent and steam such that the steam is effective to substantially exclude oxygen thereby preventing ignition of the organic solvent vapour;

(e) condensing the vapour; and

(f) separating the solvent from the condensate.

**14.** A process as claimed in Claim 13 in which the vapour produced in step (d) passes into a zone which, at the commencement of or prior to step (d), is filled with an inert gaseous fluid which substantially excludes oxygen from said zone during the initial production of said vapour.

**15.** A process as claimed in Claim 14 in which said inert fluid is derived by vaporisation of a highly fluorinated organic compound in its liquid phase, the boiling point of said compound being less than the temperature at which the organic solvent and water are vaporised by steam distillation.

**16.** A process as claimed in Claim 15 in which heat generated to effect steam distillation in step (d) is also employed to effect vaporisation of said highly fluorinated organic compound.

**17.** A process as claimed in Claim 15 in which the steam distillation of step (d) and the vaporisation of said highly fluorinated organic compound are carried out in the same vessel using the same source of heat.

**18.** A process as claimed in any one of Claims 14 to 17 in which the gaseous fluid component is substantially removed from said zone when the temperature attained within said zone reaches a value indicative of the presence in said zone of sufficient water vapour to exclude oxygen and in which, upon cessation of steam distillation, said inert gaseous fluid is re-introduced into said zone.

**19.** Plant for effecting cleaning of articles, comprising means for effecting contact between the articles and a non-chlorinated solvent at a temperature below the flashpoint of the solvent, means for contacting the solvent bearing articles with an aqueous rinsing medium at a temperature below the flashpoint of the solvent, means for collecting the contaminated solvent, means for effecting steam distillation of the collected solvent to produce vapour containing the solvent and steam, means for condensing the vapour and separating the solvent from the condensate, and means for recycling solvent obtained by steam distillation to the solvent-contacting means.

**20.** Cleaning plant as claimed in Claim 19 in which said means for effecting steam distillation comprises a vessel in communication with said solvent collecting means, said vessel containing organic solvent and water and having a headspace into which vapour produced by steam distillation passes, and in which means is provided for substantially filling said headspace of the vessel with an inert gaseous fluid at, or prior to, the commencement or cessation of operation of said means for effecting steam distillation, said filling means being arranged to substantially remove said inert gaseous fluid from the headspace of the vessel in response to the production by the steam distillation means of sufficient solvent/water vapour to substantially exclude oxygen from said headspace.

**21.** A method of distilling a mixture to separate first and second volatile liquid components from a contaminant which is substantially non-volatile or has lower volatility than said liquid components, the first component being flammable and the second component being substantially non-flammable, said method comprising:

heating the mixture to a temperature which is above the flashpoint of the first component to vaporise both components whereby the vaporised components pass into a zone in which they are separated from the contaminant;

while initially heating the mixture introducing into said zone an inert gas or vapour prior to said zone becoming substantially filled with said vaporised components whereby initially oxygen is substantially excluded from said zone by the inert gas or vapour;

allowing the vaporised components generated as heating continues to displace said inert gas or vapour from said zone so that oxygen is thereafter substantially excluded by the vaporised components; and

condensing the vaporised components by directing the vaporised components from said zone to condensing means while maintaining said zone substantially filled with said vaporised components.

22. A method as claimed in Claim 21 in which the inert gas or vapour is generated from the liquid phase by heating.

23. A method as claimed in Claim 22 in which the inert gas or vapour in its liquid phase has a boiling point less than the first and second components or the mixture thereof.

24. A method as claimed in Claim 22 in which heating of said liquid phase is effected using the same heating source as used for heating said mixture.

25. A method as claimed in Claim 22 in which said inert gas or vapour when in its liquid phase is contained in the same vessel as said mixture during the initial heating of the mixture.

26. A method as claimed in Claim 25 in which, during the initial heating of said mixture, the inert gas or vapour is cycled around a closed path in which it is generated by heating the liquid phase and passes into said zone, passes from said zone to a condensing means, passes from the condensing means to a reservoir for storing the liquid phase, and passes to the heating means for regeneration of the gas/vapour phase.

27. A method as claimed in Claim 26 in which, after the temperature in said zone has attained a predetermined value, cycling of the inert gas/vapour around said path is discontinued by preventing passage of the liquid phase from the storage reservoir to the heating means.

28. A method as claimed in any one of Claims 21 to 27 in which, on discontinuance of heating with accompanying cessation of generation of said vaporised components, the inert gas or vapour is re-introduced into said zone whereby, during cooling down of the mixture, oxygen is substantially excluded from said zone by the inert gas or vapour.

29. Distillation apparatus for use in distilling a mixture to separate first and second volatile liquid components from a contaminant which is substantially non-volatile or is substantially less volatile than said liquid components, the first component being flammable and the second component being substantially non-flammable, said apparatus comprising:

means for heating the mixture in a vessel to a temperature which is above the flashpoint of the first component to vaporise both components whereby the vaporised components pass into a zone in which they are separated from the contaminant;

means operable during initial heating of the mixture to introduce into said zone an inert gas or vapour prior to said zone becoming substantially filled with said vaporised components whereby initially oxygen is substantially excluded from said zone by the inert gas or vapour;

means for allowing the vaporised components generated as heating continues to displace said inert gas or vapour from said zone so that oxygen is thereafter substantially excluded by the vaporised components; and

means in communication with said zone for receiving and condensing the vaporised components at a rate such that said zone remains substantially filled with said vaporised components.

30. Apparatus as claimed in Claim 29 in which said means for introducing the inert gas or vapour is operable to generate the inert vapour or gas by heating an inert compound in its liquid phase.

31. Apparatus as claimed in Claim 30 in which said means for introducing the inert gas or vapour defines a closed path around which the inert fluid is circulated, said path comprising said zone, the condensing means and said vessel.

32. Apparatus as claimed in Claim 31 in which heating of said liquid phase is effected using the same heating source as used for heating said mixture.

33. Apparatus as claimed in Claim 31 or 32 in which said closed path further includes a storage reservoir through which the inert fluid is allowed to flow during initial heating of said mixture, means being provided for controlling communication between the storage reservoir and said vessel and being operable selectively to isolate the contents of the reservoir to terminate the supply of said inert gas or vapour to said zone.

Fig. 1.

# Fig. 2.

# Fig. 3.

# Fig.4.